Europäisches Patentamt

European Patent Office

Office européen des brevets

(11) Publication number: **0 026 955**
**A1**

(12) **EUROPEAN PATENT APPLICATION**

(21) Application number: **80200935.7**

(22) Date of filing: **02.10.80**

(51) Int. Cl.³: **G 10 H 1/46,** G 10 H 1/14,
H 03 G 5/18

(30) Priority: **03.10.79 NL 7907336**
**02.04.80 NL 8001938**

(43) Date of publication of application: **15.04.81**
**Bulletin 81/15**

(84) Designated Contracting States: **AT BE CH DE FR GB IT**
**LI LU NL SE**

(71) Applicant: **B.V. "Eminent" Fabriek van electronische**
**orgels, Dronenhoek 1, NL-2410 AA Bodegraven (NL)**

(72) Inventor: **Venema, Tjeerd, Echterstraat 7, Maasbracht**
**(NL)**

(74) Representative: **Kooy, Leendert Willem et al, Dr.**
**Kuyperstraat 6, NL-2514 BB Den Haag (NL)**

(54) Electronic musical instrument having means for generating long reverberating sounds.

(57) Electronic musical instrument having at least a channel carrying an electrical signal for generating long rever-
berating sounds, wherein each of at least a number of the
said channels comprises an automatic volume control de-
vice (7) under control of a control signal (4) having a time
dependent characteristic similar to that of the envelope of
the controlled electrical signal (1) in the channel itself, said
volume control device (7) adjusting in a frequency dependent way the transfer function of the channel, a relatively
low amplitude control signal favouring the significant parts
of the transfer function in the frequency band where the
sense of hearing is nominally most acute above the frequency band or bands where the sense of hearing is no-
minally feeble.

- 1 -

ELECTRONIC MUSICAL INSTRUMENT HAVING MEANS FOR
GENERATING LONG REVERBERATING SOUNDS

BACKGROUND OF THE INVENTION

The present invention relates to an electric musical instrument having at least one channel carrying an electrical signal for generating long reverberating sounds.

Similar electronic musical instruments are known, e.g. an electronic musical instrument imitating a keyed stringed instrument, such as piano and spinet. With the known electronic musical instruments of the said type the problem arises that the musical sound quality appears to be unsatisfactory each time when the sound volume is relatively small. The fact is that this unsatisfactory sound quality is the result of spurious signals, such as hum originating from the electrical supply and by interference. Further the unsatisfactory sound quality can be caused by noise signals and interfering signals stemming from electronic switching elements and by cross talk coupled capacitively and/or inductively or even by galvanic way from the generator systems into the instrument. In fact electronic musical instruments of the said type thus have a very limited dynamic range.

- 2 -

SUMMARY OF THE INVENTION

The present invention provides a solution for the said problem. An electronic musical instrument of the type described in the preamble is therefor characterized in that each of at least a number of the said channels comprises an automatic volume control device under control of a control signal having a time dependent characteristic similar to that of the envelope of the controlled electrical signal in the channel itself, said volume device adjusting in a frequency dependent way the transfer function of the channel, a relatively low amplitude control signal favouring the significant parts of the transfer function in the frequency band where the sense of hearing is nominally most acute above the frequency band or bands where the sense of hearing is nominally feeble.

The present invention is hereafter illustrated by a description of a number of embodiments. The description refers to a drawing.

DRAWING

Figure 1 shows in a plot of volume against time the volume characteristic of a stringed instrument sound from the point of time whereupon sound volume is maximal.

Figure 2 shows schematically a direct voltage controlled frequency-dependent amplifier as an embodiment of the invention.

Figure 3 shows schematically a voltage controlled frequency-dependent attenuator as an embodiment of the invention.

Figure 4 shows an embodiment of an automatic volume control device according to the invention.

Figure 5 shows an embodiment of an automatic volume control device being a variation of the embodiment shown in figure 4.

Figure 5A shows a detail of the apparatus shown in figure 5.

Figure 6 shows a further embodiment of an automatic volume control device according to the invention.

DESCRIPTION OF PREFERRED EMBODIMENTS

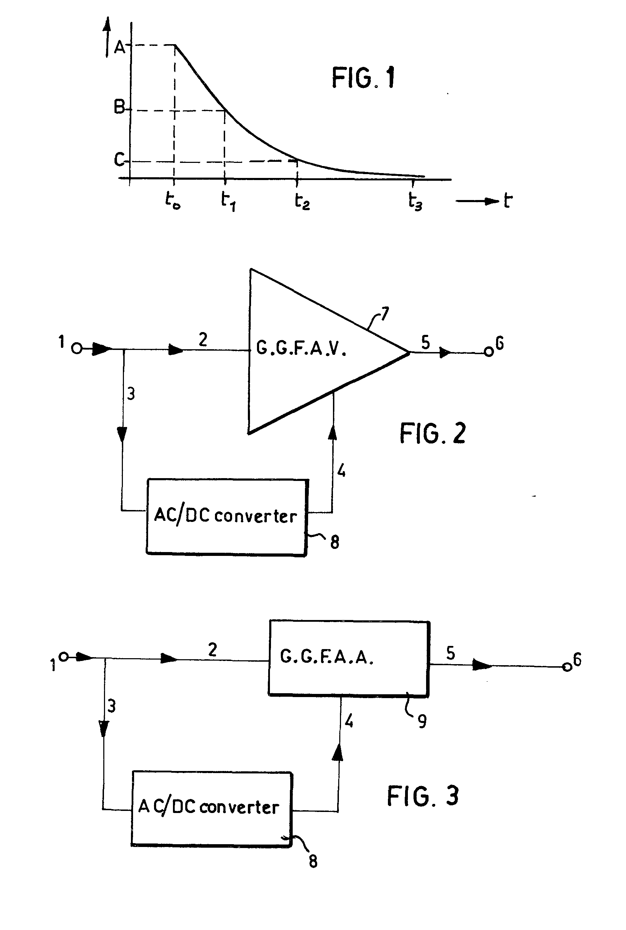

Figure 1 shows the volume characteristic of a stringed instrument sound from the point of time $t_0$ whereupon sound volume is maximal. At this point of time $t_0$ the amplitude amounts to A. The sound is decaying and finally its amplitude at the point if time $t_3$ is practically zero. By varying during the decay of the sound the transfer function of the channel wherein the electrical signal generating the sound is carried, the dynamic range of said channel can be effected favourably. At the point of time $t_1$ where the amplitude of the electrical signal is corresponding with the amplitude B of the generated sound a gradual influencing of the signal is initiated in order to suppress annoying noise and spurious signals in proportion with the further reduction of the sound volume. The electrical signal generating the sound is left intact as much as possible. Moreover, clicks from suddenly connecting filter stages for example are eliminated. So at the point of time $t_2$ and an amplitude C the reduction by selective attenuation of noise and spurious signals will be considerably more substantial than at the point of time $t_1$. The time interval, determined by the points of time $t_0$ and $t_3$, has a duration which can range from 0.1 - 30 seconds dependent on the nature of the imitated instrument.

<u>The DC voltage controlled frequency-dependent ampli-</u>
<u>fier.</u>

In figure 2 the correctly filtered or not stringed keyboards instrument signal is fed to terminal 1. This signal is led via lead 2 towards the input of a DC voltage controlled frequency-dependent amplifier 7, now briefly called G.G.F.A.V. The output thereof is lead 5 where the stringed keyboard instrument signal emerges again, to be processed further via terminal 6. The G.G.F.A.V. 7 will apply, when it is not controlled via lead 4 with a signal from the AC/DC converter 8, full frequency corrections necessary to suppress all spurious noises. When a musical signal is fed to terminal 1, it will be rectified and as an option be amplified via the AC/DC converter 8. The resulting voltage controls via lead 4 the G.G.F.A.V. 7 which now does not apply any more corrections and has the input signal from terminal 1 passing without any frequency dependent correction. However, when the signal amplitude at terminal 1 decreases, the DC voltage on lead 4 is also reduced. So the G.G.F.A.V. 7 is adjusted again and frequency correction is rein-itiated, said frequency correction suppressing the spurious noise signals on lead 2 and providing a corrected signal on lead 5. The smaller the signal amplitude at terminal 1, the lower the direct voltage on lead 4 and the frequency correction in the G.G.F.A.V. 7 increases accordingly. The method discussed heretofore provides for an enlargement of dynamic range by having an amplifier stage (G.G.F.A.V. 7) operate in a frequency dependent way. The frequency dependent correction only begins when the signal amplitude of the music signal is becoming so small that the spurious noises are no longer masked and the frequency-correction increases in proportion to the decrease of the original musical signal amplitude.

### The DC voltage controlled frequency-dependent attenuator.

The DC voltage controlled frequency-dependent attenuator shown in figure 3 operates substantially in the same way as the amplifier shown in figure 2. The reference numerals correspond with those in figure 2. The difference in the circuit is found in the DC voltage controlled frequency-dependent attenuator G.G.F.A.A. 9. Frequency-correction here is applied to the basis of an attenuator principle. In the embodiment of figure 2 the frequency-correction is effectuated by gradually decreasing amplication in amplifier stage G.G.F.A.V. 7 at predetermined frequencies, so that spurious noises are eliminated. In the figure 3 embodiment frequency correction is effectuated by attenuating spurious noises. When the musical signal is maximal at terminal 1/2/3 no significant attenuation is caused. On the other hand when there is no musical instrument signal at terminal 1/2/3, the attenuation of the frequencies in order to suppress the secondary noises is maximal. The control of the G.G.F.A.A. 9 is also taking place via an AC/DC converter supplying the control voltage for the frequency dependent attenuator. When there is no signal on lead 4, the G.G.F.A.A. 9 is attenuating the spurious noises maximally. With a maximal signal at terminal 1/2/3 the frequency corrected attenuation is cancelled, subsequently with decreasing amplitude, the frequency corrected attenuation increases and finally it is maximal when the signal amplitude at terminal 1/2/3 has become so small that it can be neglected.

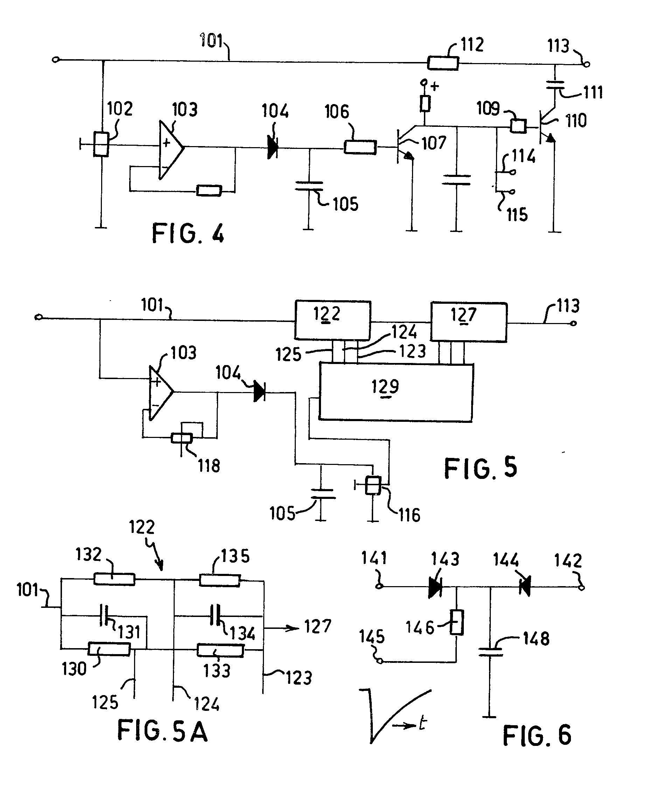

In figure 4 an embodiment of a volume control circuit is shown with a portion 101 of the electrical sound generator channel, said volume control circuit affecting the transfer function of said channel portion. Via a potentiometer 102 the signal voltage in channel 101 is partially supplied to an operational amplifier 103 which is passing as a buffer the signal voltage part to a rectifier stage consisting of a diode 104 and a capacitor 105. The rectified signal voltage that is the envelope of the signal voltage part, is fed to the basis of a transistor 107 via a resistor 106. At the start of the signal wave form for generating a sound of a stringed instrument for example, the transistor 107 is brought relatively fast in its conducting state. The adjust-ment of said transistor 107 has now been chosen such that at a value of the voltage supplied by the rectifying stage corresponding with the amplitude B in figure 1, the conductivity of transistor 107 will start decreasing. Said conductivity decreases further with the lowering of the decaying electrical signal wave form applied at the basis of the transistor 107. Thus said transistor 107 acts as a linear inverter reversely reproducing the slope of the applied signal wave form in the signal supplied by the inverter, however, starting from a predetermined value of the amplitude of the applied signal wave form dependent on the pitch of the sound connected with channel portion 101, taking into account the standard sensitivity of the human ear for said pitch.

The output signal of the inverter is utilized as a DC voltage control signal for a filter being variable as to its frequency characteristic and comprising a resistor 112 in channel portion 101, a capacitor 111 and a transistor 110. The control signal supplied by the inverter at full conductivity, is too small to maintain transistor 110 in its conducting state.

When the control signal is increasing, transistor 110 gradually attains its conductive state and this in proportion with the decrease of the control signal according to the amplitude reduction of the decaying sound generating signal in channel portion 101 as presented via operational amplifier 103. Herewith the cut off frequency of the RC-member consisting of the resistor 112 and the capacitor 111, is moved downwards, so that the output terminal 113 of channel 101 delivers a signal wave form that is free from spurious signals according to the sound reproducing signal in channel portion 101 itself is getting smaller.

The output means 114 and 115, equally connected to the output transistor 107 can be utilized to connect up and control a similar filter stage as stage 9, 10, 11, 12, though in different sound signal generating channel.

The control circuit according to figure 4 is utilized in a channel 101 carrying a range of tone signals corresponding with an octave for example. The same can be said of the volume control circuit as shown in figure 5.

The volume control circuit according to figure 5 is a modification of the volume control circuit according to figure 4 and the same reference numerals are used for corresponding parts. The operational amplifier 103 operative as a buffer circuit, comprises a feed back means being adjustable with a potentiometer 118. Further the output signal of the rectifier stage 104, 105 is supplied to a potentiometer 116 and the stepped down signal is supplied to an integrated circuit 129 of the type TCA 740 acting as a double DC voltage controlled sound volume controller means for controlling sound volume in two stereo channels. In the present case the double circuit is utilized for controlling the transfer function in two identical networks 122 and 127, respectively, both comprised in channel 101 in serial connection and in series with the output terminal 113 channel 101.

In figure 5A said network 122 is shown in detail. The connecting leads 123, 124 and 125 from network 122 to integrated circuit 129 are subsequently connected to the terminals of the type TCA 740-circuit indicated with 13, 14 and 15 respectively. In a typical case the capacitors 131 and 134 in network 122 have each a value of 1.8 nF and the resistors 130, 132, 133 and 135 have each a value of 39 kohm. Network 127 is similar to network 122. Each of the networks results in a noise suppression up to 12 dB when using the full scale of control means or potentiometer 116. Thus noise suppression can amount to in total 24 dB thus increasing the dynamic range of output channel 101 considerably. The variable resistor 118 in the feed back loop connected with operational amplifier 103 serves to adapt the signal level in this buffer circuit to the signal level in channel 101, and the adjustment of potentiometer 116 is directed on selecting the signal level, below which noise can be sensed.

Figure 6 shows another solution of the problem in an embodiment that can be appropriately used in a channel for a signal generating a single sound only. In such a channel between the terminals 141 and 142 there are to diodes 143 and 144 belonging to a diode gate which can be opened by supplying to the cathodes, the common connection point of the diodes, a switching voltage of which the wave form corresponds with that of the envelope of the sound signal itself as indicated in figure 6 at the input terminal 145 which is connected via a resistance 146 to the cathode of the diodes 143 and 144, said cathodes being grounded via a capacitor 148. The choice of the capacity of the capacitor 148 is related to the dynamic resistance for small signals of the diode 143 forming with the capacitor 148 a RC member. It is evident that the frequency of the sound generating signal in channel 141/142 is to be taken into account. A condition for a sound operation of the circuit shown in figure 6 is that the signal source has low internal resistance.

- 1 -

CLAIMS

1. Electronic musical instrument having at least a channel carrying an electrical signal for generating long reverberating sounds, characterized in that each of at least a number of the said channels comprises an automatic volume control device under control of a control signal having a time dependent characteristic similar to that of the envelope of the controlled electrical signal in the channel itself, said volume control device adjusting in a frequency dependent way the transfer function of the channel, a relatively low amplitude control signal favouring the significant parts of the transfer function in the frequency band where the sense of hearing is nominally most acute above the frequency band or bands where the sense of hearing is nominally feeble.

2. Electronic music instruments according to claim 1, characterized in that the volume control device comprises an input leading to a rectifier means, and a controllable filter network that is connected in the said channel in series with the output thereof, the controllable filter network receiving the rectified input signal of the volume control device as a control signal, said input signal being branched off from a channel.

3. Electronic musical instrument according to claim 2, characterized in that the control input of the filter network comprises an inverting stage.

4. Electronic musical instrument according to claim 3, characterized in that the volume control device comprises a plurality of controllable filter networks, each for a separate channel, in addition to the filter network in the channel, from which the input signal is branched off.

0026955

- 2 -

5. Electronic musical instrument according to claim 1, characterized in that the automatic volume control device in a diode gate circuit for controlled passing a generator signal in a channel towards a reproducing output means comprises using, by means of a suitable termination via a capacitor, the one diode via which diode the generator signal is fed in, the value of said terminating capacitor being selected to be so large that the dynamic diode resistance and the said capacitor provide the desired transfer function, when the diode gate circuit has a relatively small opening under control of the control signal.

JEV/eb/TvdS

FIG. 1

FIG. 2

FIG. 3

FIG. 4

FIG. 5

FIG. 5A

FIG. 6

## European Patent Office

## EUROPEAN SEARCH REPORT

| DOCUMENTS CONSIDERED TO BE RELEVANT | | | CLASSIFICATION OF THE APPLICATION (Int. Cl.³) |
|---|---|---|---|

| Category | Citation of document with indication, where appropriate, of relevant passages | Relevant to claim |
|---|---|---|
| | US - A - 2 606 969 (H.H. SCOTT) <br> * Column 3, line 3 to column 4, line 7; figures * | 1-4 |
| | US - A - 2 606 972 (H.H. SCOTT) <br> * Column 3, line 3 to column 4, line 9; figures * | 1-4 |
| | US - A - 3 911 776 (M.L. BEIGEL) <br> * Column 15, line 66 to column 16, line 29; figures * | 1-3 |
| | US - A - 3 391 240 (D.M. UETRECHT) <br> * Column 6, lines 8-55; figures 1-3 * | 1,4,5 |
| A | US - A - 3 762 265 (T. ADACHI) <br> * Figure 4; column 5, lines 21-39 * | 1 |
| A | US - A - 4 050 343 (R.A. MOOG) <br> * Figure 1 * | 1 |
| A | US - A - 3 948 139 (B. MELCHER et al.) <br> * Figure 1 * | 1 |
| A | US - A - 3 921 077 (K. SUZUKI) <br> * Figure 1 * | 1,2 |

**CLASSIFICATION OF THE APPLICATION (Int. Cl.³)**

G 10 H 1/40
1/14
H 03 G 3/1x

**TECHNICAL FIELDS SEARCHED (Int. Cl.³)**

G 10 H 1/40
1/14
1/05;
1/1x
1/05x
x/00
H 03 G 3/10
x/1x
x/20
x/22

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 20-01-1981 | EXE... |

EPO Form 1503.1   06.78